# EUROPEAN PATENT SPECIFICATION

(11) **EP 2 772 902 B1**
(45) Date of publication and mention of the grant of the patent: **20.03.2019**
(21) Application number: 12790780.6
(22) Date of filing: 26.10.2012
(51) Int. Cl.: G11C 19/18, G09G 3/36

(54) **GATE LINE DRIVE METHOD, SHIFT REGISTER, GATE LINE DRIVE APPARATUS AND DISPLAY DEVICE**
ANSTEUERVERFAHREN UND ANSTEUERVORRICHTUNG FUR GATE LEITUNGEN, SHIEBEREGISTER UND ANZEIGEVORRICHTUNG
PROCÉDÉ DE COMMANDE DE LIGNES DE RÉSEAU, REGISTRE À DÉCALAGE, APPAREIL DE COMMANDE DE LIGNES DE RÉSEAU ET DISPOSITIF D'AFFICHAGE

(30) Priority: 26.10.2011 CN 201110331772
(43) Date of publication of application: 03.09.2014
(73) Proprietor: Beijing BOE Optoelectronics Technology Co., Ltd., Beijing 100176 (CN)
(72) Inventor: CAO, Kun, Beijing 100176 (CN); HU, Ming, Beijing 100176 (CN)
(74) Representative: Brötz, Helmut
(86) International application number: PCT/CN2012/083558
(87) International publication number: WO 2013/060285

(56) References cited:
- EP-A2- 1 445 862
- CN-A- 101 089 939
- CN-A- 101 093 647
- CN-A- 101 546 607
- CN-A- 101 677 021
- CN-A- 102 012 591
- CN-A- 102 629 459
- US-A1- 2007 296 681
- US-A1- 2010 182 227
- US-A1- 2010 245 337
- US-A1- 2011 058 640

## Description

### TECHNICAL FIELD

The present disclosure relates to the field of liquid crystal display, in particular, to a shifting register, a gate line driving apparatus comprising the shifting register, a display device comprising the gate line apparatus and a gate line driving method for controlling the gate line driving apparatus.

### BACKGROUND

The pixel array for a liquid crystal display includes a plurality of gate lines and a plurality of data lines which are interlaced each other, with a gate line corresponding to a row of the pixel array and a data line corresponding to a column of the pixel array. The driving for the gate lines can be implemented by an integral driving circuit attached. With the development of the process on the amorphous silicon film in recent years, it is possible to integrate the gate line driving circuit into the substrate of the Thin Film Transistor (TFT) arrays to construct a shifting register so as to drive the gate line.

The gate line driving apparatus constituted by a plurality of shifting registers provide the plurality of gate lines in the pixel array with the switching signals so that the plurality of gate lines are controlled to be switched on in sequence, and the pixel electrodes in the corresponding row in the pixel array are charged from the data lines to form the gray voltages required by the respective gray levels to display an image, and thus each frame of the image can be displayed.

It is required that, in each of the shifting registers, the thin film transistors are turned on and/or off to realize the switching-on or switching-off of the corresponding gate line. However, during the actual operation, the thin film transistors fail to be turned on normally after a period of time due to the occurrence of the threshold voltage shifting (here referring to positive shifting, i.e., the increase of the threshold voltage).

The increase of the threshold voltage for turning on the thin film transistor relates to the voltage applied between the source and the gate thereof. The higher the voltage applied between the source and the gate and the longer the time for the voltage being applied is, the more the threshold voltage for turning on the thin film transistor increases. Therefore,
if a voltage is applied to a thin film transistor all the time, the threshold voltage shifting would increase all along, which results in the failure to turn on the thin film transistor normally, and finally causes malfunction of the shifting register circuit.

US 2010/0182227 A1 discloses a gate driving circuit capable of suppressing threshold voltage drift. From US 2011/0058640 A1 it is known a shift register unit and a gate drive device for a liquid crystal display. CN 101093647 A discloses a gate driving circuit and a display apparatus having the same. From CN 101546607 A it is known a shift register and a grid driving device for a liquid crystal display. US 2010/245337 A1 discloses a shift register and a gate-line drive device therefor. From US 2007/0296681 A1 it is known a gate driving circuit and a display apparatus having the same.

### SUMMARY

The embodiments of the disclosure provide a shifting register, a gate line driving apparatus comprising the shifting register, a display device comprising the gate line apparatus and a gate line driving method for controlling the gate line driving apparatus, and can improve the stability of the shifting register in operation. The invention is defined in the claims.

It tends to form and accumulate electrons on the gate insulation layer of a thin film transistor if a voltage is applied to a gate of the thin film transistor for a long time, and thus it causes the threshold voltage of the thin film transistor to shift. In the gate line driving method, the shifting register, the gate line driving apparatus and the display device according to the embodiments of the disclosure, by applying a high level to the source of the TFT and a low level to the gate thereof, according to the principle of the tunnelling effect and the quantum mechanics, the electrons formed and accumulated on the gate insulation layer of the TFT can pass the potential barrier and arrive at the source of the TFT, and thus it decreases the threshold voltage shifting of the TFT in the shifting register corresponding to each gate line, and finally it enables the shifting register circuit to operate normally, improving the stability of the shifting register in operation and extending the lifespan of the shifting register.

### BRIEF DESCRIPTION OF THE DRAWINGS

Fig.1 is a schematic diagram of a gate line driving method according to an embodiment of the disclosure;
Fig. 2 is a schematic diagram of a shifting register according to an embodiment of the disclosure;
Fig. 3 is a schematic diagram of a specific embodiment of the shifting register of the disclosure;
Fig. 4 is a timing control chart for the shifting register shown in Fig. 3;
Fig. 5 is a schematic diagram of the shifting register shown in Fig. 3 in operation during t1 phase;
Fig. 6 is a schematic diagram of the shifting register shown in Fig. 3 in operation during t2 phase;
Fig. 7 is a schematic diagram of the shifting register shown in Fig. 3 in operation during t3 phase;
Fig. 8 is a schematic diagram of the shifting register shown in Fig. 3 in operation during t4 phase; and
Fig. 9 is a schematic diagram of a gate line driving apparatus according to an embodiment of the disclosure.

### DETAILED DESCRIPTION

Hereinafter, a gate line driving method, a shifting register, a gate line driving apparatus and a display device in accordance with the disclosure are described in detail with reference to the drawings.

It should be appreciated that all the embodiments as described are only parts of embodiments rather than all the possible embodiments of the disclosure.

It should be noted that the terms of "source" and "drain" defined in the specification and claims are interchangeable, and the direction of an arrow only represents the conduction of the transistor instead of the direction of the conduction.

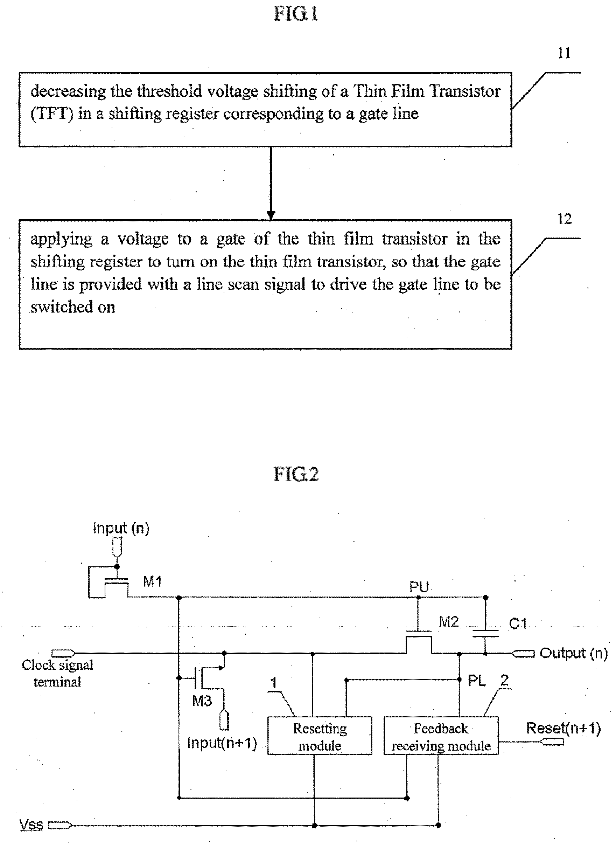

As shown in Fig. 1, it is the schematic diagram of a gate line driving method of an embodiment of the disclosure. The gate line driving method comprises:
in step 11, decreasing the threshold voltage shifting of a thin film transistor in a shifting register corresponding to a row gate line;
in step 12, applying a voltage to a gate of the thin film transistor in the shifting register to turn on the thin film transistor, so that the gate line is provided with a line scan signal to drive the gate line to be switched on.

It tends to form and accumulate electrons in the gate insulation layer of a thin film transistor if a voltage is applied to the gate of the thin film transistor all the time, and thus causes the threshold voltage of the thin film transistor to shift. According to the gate line driving method as provided in the embodiments of the disclosure, it enables the shifting
register circuit to operate normally by decreasing the threshold voltage shifting of the thin film transistor in the shifting register corresponding to each gate line, improving the stability of the shifting register in operation and extending the lifespan of the shifting register.

As known from above, the threshold voltage shifting of the thin film transistor generally results from the electrons formed and accumulated on the gate insulation layer of the thin film transistor. The Step 11 mentioned above, i.e., decreasing the threshold voltage shifting of the thin film transistor in the shifting register corresponding to a gate line can further comprise;

in step 111, allowing the electrons accumulated on the gate insulation layer of the thin film transistor to arrive at the source thereof, to decrease the threshold voltage shifting of the thin film transistor.

It should be noted that other factors can also result in the threshold voltage shifting in addition to the formation and accumulation of the electrons on the gate insulation layer of the thin film transistor, such as accumulation of the electrons on the passivation layer. Therefore, the step for decreasing the threshold voltage shifting of the thin film transistor in the shifting register corresponding to each gate line as proposed in the embodiment, can not only comprise the above step 111, but also comprise other steps, such as the step for allowing the electrons accumulated on the passivation layer to arrive at the source of the thin film transistor and the like.

the above step 111, i.e., allowing the electrons accumulated on the gate insulation layer of the TFT to arrive at the source thereof, comprises the step of: applying a high level to the source of the TFT and a low level to the gate thereof, so that the electrons accumulated on the gate insulation layer of the TFT can arrive at the source thereof.

According to the principle of the tunnelling effect and the quantum mechanics, subsequent to the application of the high level to the source of the TFT and the low level to the gate thereof, the electrons formed and accumulated on the gate insulation layer of the TFT can pass the potential barrier and arrive at the source of the TFT, and thus decreasing the threshold voltage shifting of the TFT due to the accumulation of the electrons on the gate insulation layer thereof.

Hereinafter, a shifting register is designed and manufactured according to the gate line driving method, and the shifting register has a high stability in operation. For example, as shown in Fig.2, the shifting register according to the embodiment includes three TFTs, a storage capacitor, a resetting module, a feedback receiving module, and corresponding I/O terminals. In particular, the shifting register includes:
a first TFT M1, having a gate and a source connected together and further connected to a trigger signal terminal Input(n) at the present stage (i.e., at the n^{th} stage), and a drain connected to a first node PU as a pull-up node, for controlling the shifting register to start operation upon receiving a high level signal sent from the trigger signal terminal Input(n), wherein the trigger signal terminal Input(n) receives a high level signal when an output terminal Output(n-1) of the shifting register at the previous stage (i.e., the shifting register at the (n-1)^{th} stage) outputs a high level;
a second thin film transistor M2, having a gate connected to the first node PU, a source connected to a clock signal terminal, and a drain connected to an output terminal Output(n) at the present stage, for providing a high level output for the output terminal Output(n) to drive the gate line corresponding to the shifting register at the present stage (i.e., the shifting register at the n^{th} stage) to be switched on;
a third TFT M3, having a gate connected to the first node PU, a source connected to the clock signal terminal, and a drain connected to a trigger signal terminal Input(n+1) for the next stage (i.e., the (n+1)^{th} stage), for providing a trigger signal for the shifting register at the next stage(i.e., the shifting register at the (n+1)^{th} stage) to control the same to start operation;
a capacitor C1, being connected between the first node PU and the output terminal Output(n) at the present stage;
a resetting module 1, being connected between a second node PL as a pull-down node, the clock signal terminal and a low level signal terminal Vss, for applying a low level to the drain and the gate of the second TFT M2 after the output of the present stage is completed; and
a feedback receiving module 2, being connected between the first node PU, the low level signal terminal Vss and the output terminal Output(n) at the present stage, and being further connected to the feedback signal terminal Reset(n+1), for receiving a feedback signal from the next stage to pull down the levels at the first node PU and the output terminal Output(n) at the present stage, wherein the feedback signal terminal Reset(n+1) receives a high level signal when the output terminal Output(n+1) of the shifting register at the next stage (i.e., the shifting register at the (n+1)^{th} stage) outputs a high level; and the feedback signal terminal Reset(n+1) can be either connected to the output terminal Output(n+1) of the shifting register at the next stage (i.e., the shifting register at the (n+1)^{th} stage), or connected to a trigger signal terminal Input(n+2) of the shifting register at the stage subsequent to the next stage of the present stage (i.e., the shifting register at the (n+2)^{th} stage).

It should be noted that although the shifting register in Fig.2 includes three TFTs, the embodiments of the disclosure are not limited thereto. For example, in a shifting register according to an embodiment of the disclosure, the third TFT M3 can be excluded, and the output terminal Output(n) at the present stage connected to the drain of the second TFT M2 can serve to be connected to the trigger signal terminal Input(n+1) for the next stage.

Thus, a shifting register according to another embodiment of the disclosure includes two TFTs, a storage capacitor, a resetting module, a feedback receiving module and corresponding I/O terminals. In particular, the shifting register includes:
a first TFT M1, having a gate and a source connected together and further connected to a trigger signal terminal Input(n) at the present stage, and a drain connected to a first node PU as a pull-up node, for controlling the shifting register to start operation upon receiving a high level signal sent from the trigger signal terminal Input(n) at the present stage, wherein the trigger signal terminal Input(n) receives a high level signal when an output terminal Output(n-1) of the shifting register at the previous stage (i.e., the shifting register at the (n-1)^{th} stage) outputs a high level;
a second TFT M2, having a gate connected to the first node PU, a source connected to a clock signal terminal, and a drain connected to an output terminal Output(n) at the present stage and a trigger signal terminal Input(n+1) for the next stage, for providing a high level output for the output terminal Output(n) at the present stage so as to drive the gate line corresponding to the shifting register at the present stage (i.e., the shifting register at the n^{th} stage) to be switched on, and to provide a trigger signal for the shifting register at the next stage (i.e., the shifting register at the (n+1)^{th} stage) to control the same to start operation;
a capacitor C1, being connected between the first node PU and the output terminal Output(n) at the present stage;
a resetting module 1, being connected between a second node PL as a pull-down node, the clock signal terminal and a low level signal terminal Vss, for applying a low level to the drain and the gate of the second TFT M2 after the output of the present stage is completed; and
a feedback receiving module 2, being connected between the first node PU, the low level signal terminal Vss and the output terminal Output(n) at the present stage, and being further connected to a feedback signal terminal Reset(n+1), for receiving a feedback signal from the next stage to pull down the levels at the first node PU and the output terminal Output(n) of the present stage, wherein the feedback signal terminal Reset (n+1) receives a high level signal when the output terminal Output(n+1) of the shifting register at the next stage (i.e., the shifting register at the (n+1)^{th} stage) outputs a high level; and the feedback signal terminal Reset(n+1) can be connected to the output terminal Output(n+1) of the shifting register at the next stage (i.e., the shifting register at the (n+1)^{th} stage), or the feedback signal terminal Reset(n+1) can be connected to another TFT (e.g., the TFT M3 in Fig.2) which is added to the shifting register at the next stage (i.e., the shifting register at the (n+2)^{th} stage) for providing a feedback signal.

It tends to form and accumulate electrons in the gate insulation layer of a thin film transistor if a voltage is applied to the thin film transistor all the time, and thus causes the threshold voltage of the thin film transistor to shift. According to the shifting register provided in the embodiment of the disclosure, based on the principle of the tunnelling effect and the quantum mechanics, by applying a high level to the source of the TFT and a low level to the gate thereof, the electrons formed and accumulated on the gate insulation layer of the TFT can pass the potential barrier and arrive at the source thereof to decrease the threshold voltage shifting of the TFT in the shifting register corresponding to each gate line, and thus it allows the shifting register circuit to operate normally, improving the stability of the shifting register in operation and extending the lifespan of the shifting register. It should be illustrated that, the threshold voltage shifting occurs in the individual TFTs in the shifting register due to the formation and accumulation of the electrons on the gate insulation layer of the corresponding TFTs, so the corresponding TFTs in the shifting register can be provided with a resetting module 1, for applying a high level to the source of the TFT and a low level to the gate thereof after the output of the present stage of the shifting register is completed, such that the electrons at the gate insulation layer of the TFT can arrive at the source thereof to decrease the threshold voltage shifting of the TFT. Since in the shifting register, the second TFT M2 can switch on the connection between the clock signal terminal and the output terminal of the present stage to allow the gate line corresponding to the shifting register to be switched on, the second TFT M2 plays a very important role in the shifting register. Once the second TFT M2 fails to be turned on normally due to the threshold voltage shifting, the quality of the display will be affected. In addition, the opeation current in the second TFT M2 is large in general, which tends to cause the threshold voltage shifting. Therefore, taking the second TFT M2 as an example in the embodiment, it describes how to decrease the threshold voltage shifting of the TFT by use of the resetting module 1. It should be appreciated that the description is only for illustration and not for limitation.

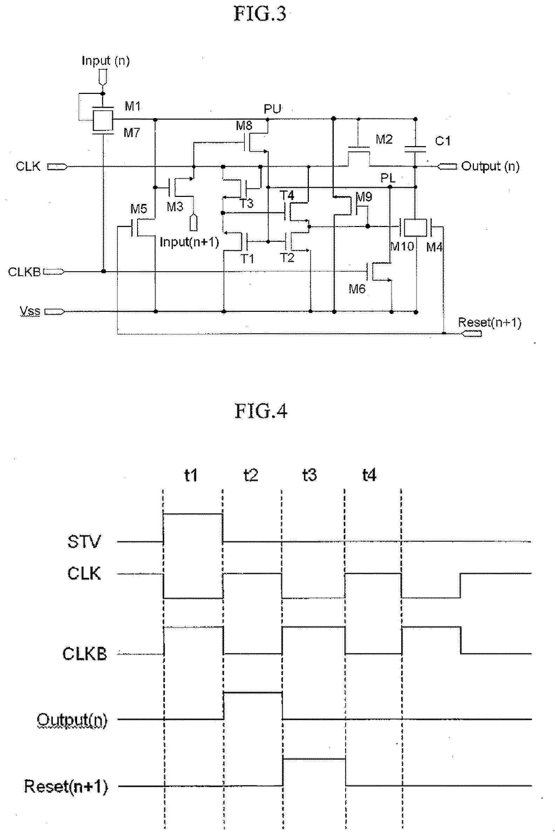

As shown in Fig. 3, it is a schematic diagram of a shifting register of a specific exemplary embodiment of the invention. It can be known from the Fig. 3, the shifting register includes fourteen TFTs, a storage capacitor, and corresponding I/O terminals. The fourteen TFTs are as follows respectively: a first TFT M1, a second TFT M2, a third TFT M3, a fourth TFT M4, a fifth TFT M5, a sixth TFT M6, a seventh TFT M7, an eighth TFT M8, a ninth TFT M9, a tenth TFT M10, a first resetting TFT T1, a second resetting TFT T2, a third resetting TFT T3, and a fourth resetting TFT T4. The storage capacitor is shown as a capacitor C1. The I/O terminals includes: a trigger signal terminal Input(n) for receiving a trigger signal from the shifting register at the previous stage; an output terminal Output(n) for outputting a level signal for the shifting register at the present stage; a trigger signal terminal Input(n+1) for sending a trigger signal to the shifting register at the next stage; a feedback signal terminal Reset(n+1) for receiving a feedback signal from the shifting register at the next stage; a low level signal terminal Vss, and clock signal terminals, wherein the clock signal terminals include a first clock signal terminal CLK and a second clock signal terminal CLKB, and a clock signal at the first clock signal terminal CLK and that at the second clock signal terminal CLKB have the same frequency and duty cycle, but only differ in phase by 180° .

In particular, the first TFT M1 has a gate and a source connected together and further connected to the trigger signal terminal Input(n) at the present stage, and a drain connected to a first node PU as a pull-up node; the second TFT M2 has a gate connected to the first node PU, a source connected to the first clock signal terminal CLK, and a drain connected to the output terminal Output(n) at the present stage; the third TFT M3 has a gate connected to the first node PU, a source connected to the first clock signal terminal CLK, and a drain connected to the trigger signal terminal Input(n+1) for the next stage; the fourth TFT M4 has a gate connected to the feedback signal terminal Reset(n+1), a source connected to the output terminal Output(n) at the present stage, and a drain connected to the low level signal terminal Vss; the fifth TFT M5 has a gate connected to the feedback signal terminal Reset(n+1), a source connected to the first node PU, and a drain connected to the low level signal terminal Vss; the sixth TFT M6 has a gate connected to the second clock signal terminal CLKB, a source connected to a second node PL, and a drain connected to the low level signal terminal Vss; the seventh TFT M7 has a gate connected to the second clock signal terminal CLKB, a source connected to the trigger signal terminal Input(n) at the present stage, and a drain connected to the first node PU; the eighth TFT M8 has a gate connected to the first clock signal terminal CLK, a source connected to the first node PU, and a drain connected to the second node PL; the ninth TFT M9 has a gate connected to a drain of the fourth resetting TFT T4 in the resetting module 1, a source connected to the first node PU, and a drain connected to the low level signal terminal Vss; the tenth TFT M10 has a gate connected to the drain of the fourth resetting TFT T4 in the resetting module 1, a source connected to the output terminal Output(n) at the present stage, and a drain connected to the low level signal terminal Vss. The first resetting TFT T1 has a gate connected to the second node PL, a source connected to a drain of the third resetting TFT M3, and a drain connected to the low level signal terminal Vss; the second resetting TFT T2 has a gate connected to the second node PL, a source connected to the drain of the fourth resetting TFT T4, and a drain connected to the low level signal terminal Vss; the third resetting TFT T3 has a gate and a source connected to the first clock signal terminal CLK, a drain connected to the source of the first resetting TFT T1; the fourth resetting TFT T4 has a gate connected to the drain of the third resetting TFT T3, a source connected to the first clock signal terminal CLK, and a drain connected to the source of the second resetting TFT T2. The storage capacitor is connected between the first node PU and the output terminal Output(n) at the present stage.

The first resetting TFT T1, the second resetting TFT T2, the third resetting TFT T3 and the fourth resetting TFT T4 have the same structures as those of the first TFT M1 to the tenth TFT M10. The first resetting TFT T1, the second resetting TFT T2, the third resetting TFT T3 and the fourth resetting TFT T4 constitute the resetting module 1 of the present embodiment, and they are differentiated from the first TFT M1 to the tenth TFT M10 in the names.

As described above, the first resetting TFT T1, the second resetting TFT T2, the third resetting TFT T3 and the fourth resetting TFT T4 constitute the resetting module 1 of the present embodiment, and the resetting module 1 is used for applying a high level to the source of the second TFT T2 and a low level to the gate thereof after the output of the present stage is completed, and thus according to the principle of the tunneling effect and the quantum mechanics, the electrons formed and accumulated at the gate insulation layer of the second TFT M2 can pass the potential barrier and arrive at the source of the second TFT M2 to decrease the threshold voltage shifting of the second TFT M2 in the shifting register corresponding to each of the gate lines, and finally it allows the shifting register circuit to operate normally, improving the stability of the shifting register in operation and extending the lifespan of the shifting register.

The fourth TFT M4 and the fifth TFT M5 constitute the feedback receiving module 2. The feedback receiving module 2 keeps the output terminal Output(n) at the present stage and the first node PU as the pull-up node at a low level when the shifting register at the present stage is not in operation and the shifting register at the next stage is in operation, so as to avoid the occurrence of the following case: the output terminal Output(n) at the present stage changes to a high level under the influence of the other interference signals, and thus causes the gate line under the control thereof to be switched on, finally resulting in the switching-on of the gate line in error. The fourth TFT M4 keeps the output terminal Output(n) at the present stage at a low level under the action of the feedback signal terminal Reset(n+1), and the fifth TFT M5 keeps the first node PU at a low level under the action of the feedback signal terminal Reset(n+1), so as to prevent the second TFT M2 from turning on in error.

As known from Fig. 3, the shifting register further includes the sixth TFT M6. The sixth TFT M6, when the shifting register at the present stage is not in operation, pulls down the second node PL as a pull-down node by receiving a high level signal at the second clock signal terminal CLKB, so as to avoid the occurrence of the following case: the output terminal Output(n) of the present stage changes to a high level under the influence of the other interference signals, and thus causes the gate line under the control thereof to be switched on, finally resulting in the switching-on of the gate line in error.

The shifting register further includes the seventh TFT M7. The seventh TFT M7 accelerates the charging process of the storage capacitor C1 when the trigger signal terminal Input(n) at the present stage is at a high level and the second clock signal terminal CLKB changes to a high level.

The shifting register further includes the eighth TFT M8. The eighth TFT M8 ensures the first node PU to be kept at a high level so as to continue to charge the capacitor C1 during the period in which the output terminal Output(n) at the present stage is at a high level (i.e., the period during which the shifting register at the present stage is in operation), further improving the turn-on capability of the second TFT M2.

In addition, the shifting register further includes the ninth TFT M9 and the tenth TFT M10, and both TFTs are combined with the resetting module 1 so that both the gate and the drain of the second TFT M2 are at a low level upon the second TFT M2 is reset; wherein, the ninth TFT M9 pulls down the first node PU to be at a low level to prevent the second TFT M2 from turning on in error, and the tenth TFT M10 pulls down the output terminal Output(n) at the present stage to be at a low level to prevent the output terminal Output(n) from changing to a high level.

It should be noted that, though the shifting register in Fig. 3 includes fourteen TFTs, the embodiments of the disclosure are not limited thereto. For example, a shifting register in accordance with another embodiment of the disclosure can exclude the third TFT M3, and the output terminal Output(n) at the present stage connected to the drain of the second TFT M2 can directly serve as the trigger signal terminal Input(n+1) for the next stage simultaneously.

Thus, a shifting register according to another embodiment of the disclosure includes thirteen TFTs, a storage capacitor, and corresponding I/O terminals. The thirteen TFTs are as follows respectively: a first TFT M1, a second TFT M2, a fourth TFT M4, a fifth TFT M5, a sixth TFT M6, a seventh TFT M7, an eighth TFT M8, a ninth TFT M9, a tenth TFT M10, a first resetting TFT T1, a second resetting TFT T2, a third resetting TFT T3, and a fourth resetting TFT T4. The storage capacitor is shown as a capacitor C1. The I/O terminals includes: a trigger signal terminal Input(n) for receiving the trigger signal from the shifting register at the previous stage; an output terminal Output(n) for outputting a level signal for the shifting register at the present stage and for sending a trigger signal to the shifting register at the next stage; a feedback signal terminal Reset(n+1) for receiving a feedback signal from the shifting register at the next stage; a low level signal terminal Vss, and clock signal terminals, wherein the clock signal terminals include a first clock signal terminal CLK and a second clock signal terminal CLKB, and a clock signal at the first clock signal terminal CLK and that at the second clock signal terminal CLKB have the same frequency and duty cycle, but only differ in phase by 180° . The operations on the thirteen TFTs are the same as those on the corresponding TFTs of the embodiment as described with reference to Fig. 3, and the details are omitted.

In practice, the TFTs in the embodiments of the disclosure can be of the type of hydrogenated amorphous TFTs, but can be of other types of TFTs.

Hereinafter, the operation process of the shifting register in the embodiment is described by combining the shifting register shown in Fig.3 with the control timing chart shown in Fig. 4.

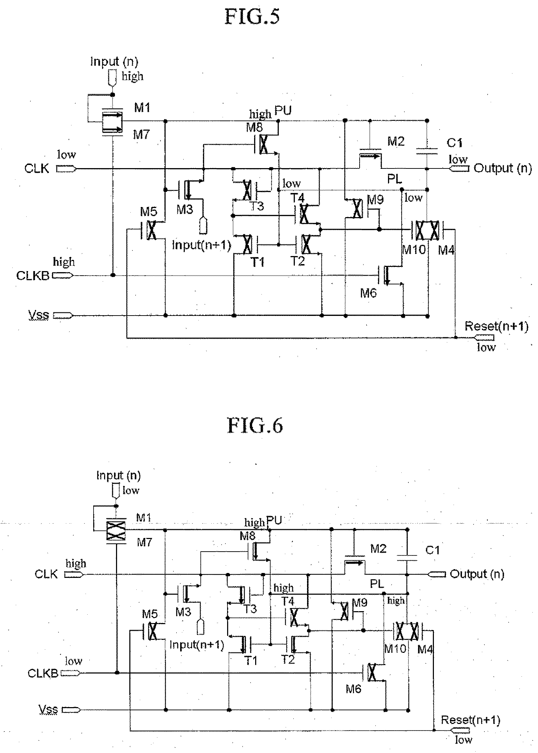

As illustrated in Fig. 4, it is the control timing chart for the shifting register in the embodiment, and there are four phases, i.e., t1, t2, t3 and t4 in the chart. The first clock signal terminal CLK and the second clock signal terminal CLKB alternate in use. STV denotes a switching signal terminal, i.e., the trigger signal terminal Input(n) at the present stage, for receiving a high level signal from the shifting register at the previous stage, wherein a high level signal is denoted by 1, and a low level signal is denoted by 0. Throughout Figs. 5-8, an arrow "↓" represents that the corresponding TFT is ON, and a cross "X" represents that the corresponding TFT is OFF.

In the phase t1, Input(n)=1, CLK=0, CLKB=1, and Reset(n+1)=0.

The signal at STV of the shifting register at the present stage is provided by the trigger signal terminal Input(n) at the present stage. As shown in Fig.5, as Input(n)=1, the first TFT M1 turns on and controls the shifting register at the present stage to start operation, and the storage capacitor C1 is charged via the first TFT M1 by a signal at the trigger signal terminal Input(n). As CLKB=1, the seventh TFT M7 turns on, the charging process of the storage capacitor C1 is accelerated via the seventh TFT M7 by a signal at the second clock signal terminal CLKB. At this time, the first node PU is pulled up and is at a high level, and the second TFT M2 turns on; since CLK=0, a low level signal at the first clock signal terminal CLK is output to the output terminal Output(n) at the present stage via the second TFT M2, and the low level signal causes the gate line corresponding to the shifting register at the present stage to be at a low level. Furthermore, since CLKB=1, the sixth TFT M6 turns on. The sixth TFT M6 pulls down the second node PL to a low level Vss when the shifting register at the present stage is not in operation, which prevents the output terminal Output(n) from changing to a high level under the influence of other interference signals. Additionally, since the first node PU is pulled up to a high level, the third TFT M3 turns on, and since the first clock signal terminal CLK=0, the trigger signal terminal Input(n+1) for the next stage is pulled down to a low level, that is, the shifting register at the present stage does not send a trigger signal to the shifting register at the next stage in the phase t1. It can be known from the above, the phase t1 is a phase during which the storage capacitor C1 is charged.

In the phase t2, Input(n)=0, CLK=1, CLKB=0, and Reset(n+1)=0.

As shown in Fig. 6, as Input(n)=0, CLKB=0, the first TFT M1 and the seventh TFT M7 turn off, and the storage capacitor C1 is no more charged via the trigger signal terminal Input(n) and the second clock signal terminal CLKB. As CLKB=0, the sixth TFT M6 turns off, and the sixth TFT M6 will not pull down the second node PL. As CLK=1, after the second TFT M2 turns on under the action of the storage capacitor C1, it outputs a high level at the first clock signal terminal CLK to the output terminal Output(n) at the present stage, and then the output terminal Output(n) at the present stage outputs the high level to the gate line corresponding to the shifting register at the present stage, turning on all the TFTs located in the row corresponding to the gate line, and the data lines begin to write signals. Since CLK=1, the eighth TFT M8 turns on and feeds back the high level at the output terminal Output(n) to the first node PU, to ensure the first node PU to be kept at a high level to continue to charge the capacitor C1, further improving the turn-on capability of the second TFT M2. After Output(n)=1, the second node PL is pulled up, and thus the first resetting TFT T1 and the second resetting TFT T2 turn on. In addition, since CLK=1, the third resetting TFT T3 turns on, and the first resetting TFT T1 can keep the gate of the fourth resetting TFT T4 at a low level by designing the width-to-length ratio of the channel of the first resetting TFT T1 and that of the third resetting TFT T3 appropriately. Moreover, the second resetting TFT T2 keeps the drain of the fourth resetting TFT T4 at a low level. Since the fourth resetting TFT T4 turns off, the ninth and tenth TFTs M9, M10 turn off, to ensure the first node PU and the output terminal Output(n) at the present stage at a high level continuously and not being pulled down. At this time, the third TFT M3 turns on, under the action of the storage capacitor C1, to allow the trigger signal terminal Input(n+1) for the next stage to change to a high level so as to send a trigger signal to the shifting register at the next stage. In summary, the phase t2 is the phase during which a high level is output to the output terminal Output(n) of the shifting register at the present stage.

In the phase t3, Input(n)=0, CLK=0, CLKB=1, and Reset(n+1)=1.

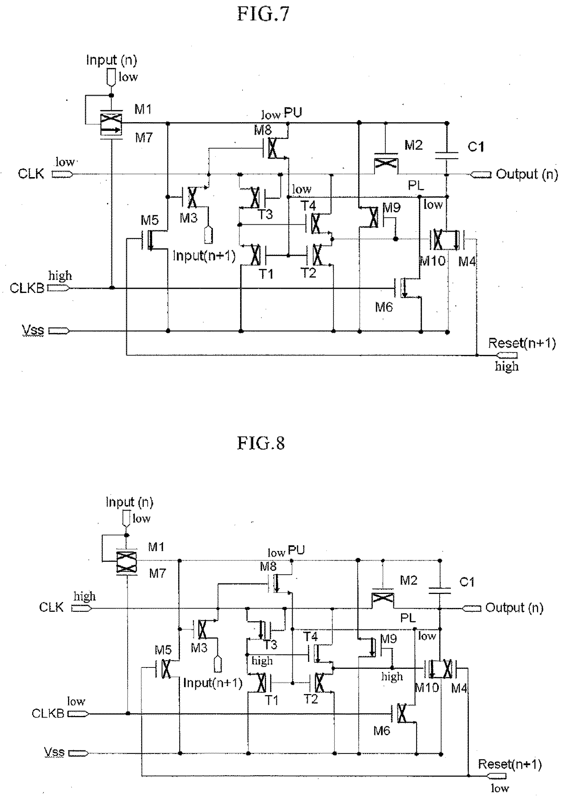

The Reset signal of the shifting register at the present stage is provided from the feedback signal terminal Reset(n+1). As shown in Fig.7, since Reset(n+1)=1, the fourth TFT M4 and the fifth TFT M5 turn on, the output terminal Output(n) is pulled down to Vss after the fourth TFT M4 turns on, and the first node PU is pulled down to Vss after the fifth TFT M5 turns on, so as to avoid the occurrence of the following case: the output terminal Output(n) at the present stage changes to a high level under the influence of the other interference signals, and thus causes the gate line under the control thereof to be switched on under the action of a high level, finally resulting in the switching-on of the gate line in error. Furthermore, since CLKB=1, the sixth TFT M6 turns on, and it pulls the second node PL down to Vss when the shifting register at the present stage is not in operation, to prevent the output terminal Output(n) at the present stage from changing to a high level under the influence of the other interference signals. In summary, the phase t3 is the phase during which a high level is output to the output terminal Output(n+1) of the shifting register at the next stage.

In the phase t4, Input(n)=0, CLK=1, CLKB=0, and Reset(n+1)=0.

As shown in Fig.8, since CLK=1, the third resetting TFT T3 turns on, which causes the gate of the fourth resetting TFT T4 to change to a high level, and thus the fourth resetting TFT T4 turns on. In addition, since the fourth resetting TFT T4 turns on, the gate of the ninth TFT M9 and that of the tenth TFT M10 change to a high level, and thus the ninth and the tenth TFTs M9, M10 turn on. The ninth TFT M9 pulls the first node PU down to Vss, and the tenth TFT M10 pulls the output terminal Output(n) down to Vss, so that both the gate and the drain of the second TFT M2 are at a low level when the second TFT M2 is reset. At this time, for the second TFT M2 with the source to which a high level being applied and the gate to which a low level being applied, the electrons accumulated on the gate insulation layer of the second TFT M2 can pass the potential barrier to arrive at the source of the second TFT M2, and thus the threshold voltage shifting thereof is decreased. In summary, the phase t4 is the phase during which the resetting module 1 resets the second TFT M2, i.e., the resetting phase of the shifting register at the present stage.

It can be known from the above descriptions, the shifting register in the embodiment can decrease the threshold voltage shifting of the TFTs in the shifting register corresponding to each of the gate lines, and finally it enables the shifting register circuit to operate normally, improving the stability of the shifting register in operation and extending the lifespan of the shifting register.

For the same reasons, the above operation process can be also applied to the embodiment in which the third TFT M3 is excluded, and the details are omitted.

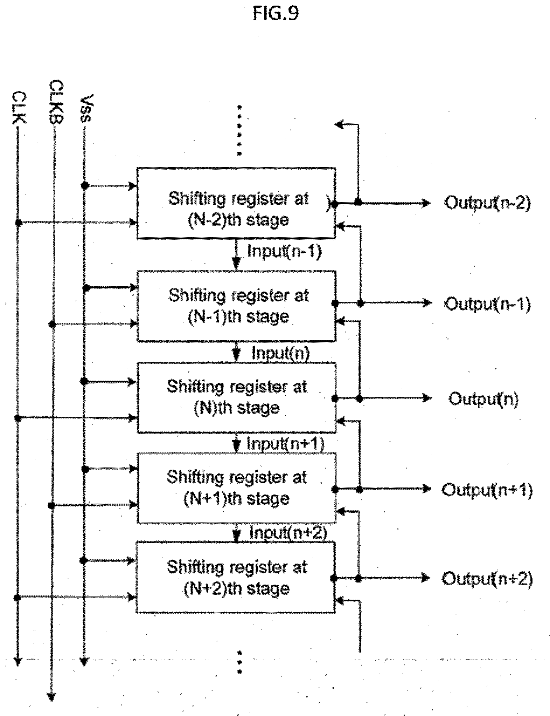

Moreover, another embodiment of the disclosure also provides a gate line driving apparatus. As shown in Fig.9, the gate line driving apparatus includes a plurality of shifting registers connected in series, and for the sake of simplicity, it is only shown five shifting registers in Fig. 9, i.e., the (N-2)^{th} shifting register, the (N-1)^{th} shifting register, the N^{th} shifting register, the (N+1)^{th} shifting register, and the (N+2)^{th} shifting register, respectively. The output terminal Output(n) of the N^{th} shifting register not only feeds back a feedback signal to the (N-1)^{th} shifting register to switch off the (N-1)^{th} shifting register, but also outputs a trigger signal to the (N+1)^{th} shifting register for triggering the (N+1)^{th} shifting register.

Beside this, as shown in Fig.9, for the shifting register at individual stages, the clock signal CLK and the clock signal CLKB alternate in use. In particular, it is illustrated that the clock signal terminal of the N^{th} shifting register receives the clock signal CLK, and that the clock signal terminals of the (N-1)^{th} and (N+1)^{th} shifting registers receive the clock signal CLKB. Therefore, the clock signal for the N^{th} shifting register and those for the (N-1)^{th} and (N+1)^{th} shifting registers have totally inverted phases, that is, differ in phase by 180° .

In another case, that is, the case that the clock signal terminals includes a first clock signal terminal and a second clock signal terminal, for the shifting registers at individual stages, the clock signal CLK and the clock signal CLKB also alternate in use. For the N^{th} shifting register, its first clock signal terminal receives the clock signal CLK and its second clock signal terminal receives the clock signal CLKB, while for the (N-1)^{th} shifting register and the (N+1)^{th} shifting register, their first clock signal terminal receives the clock signal CLKB, and their second clock signal terminal receives the clock signal CLK.

As shown in Fig.2, the shifting register at each stage includes three TFTs, a storage capacitor, a resetting module, a feedback receiving module, and corresponding I/O terminals. In particular, the shifting register includes:
a first TFT M1, having a gate and a source connected together and further connected to the trigger signal terminal Input(n) at the present stage, and a drain connected to a first node PU as a pull-up node, for controlling the shifting register to start operation upon receiving a high level signal sent from the trigger signal terminal Input(n), wherein the trigger signal terminal Input(n) receives a high level signal when an output terminal Output(n-1) of the shifting register at the previous stage (i.e., the shifting register at the (n-1)^{th} stage) outputs a high level; a second thin film transistor M2, having a gate connected to the first node PU, a source connected to a clock signal terminal, and a drain connected to the output terminal Output(n) at the present stage, for providing a high level to the output terminal Output(n) to drive a gate line corresponding to the shifting register at the present stage (i.e., the shifting register at the n^{th} stage) to be switched on; a third TFT M3, having a gate connected to the first node PU, a source connected to the clock signal terminal, and a drain connected to the trigger signal terminal Input(n+1) for the next stage, for providing a trigger signal for the shifting register at the next stage (i.e., the shifting register at the (N+1)^{th} stage) to control the same to start operation; a capacitor C1, being connected between the first node PU and the output terminal Output(n) at the present stage; a resetting module 1, being connected between a second node PL as a pull-down node, the clock signal terminal and a low level signal terminal Vss, for applying a high level to the source of the second TFT M2 and a low level to the gate thereof after the output of the present stage is completed; and a feedback receiving module 2, being connected between the first node PU, the low level signal terminal Vss and the output terminal Output(n) at the present stage, and being further connected to the feedback signal terminal Reset(n+1), for receiving a feedback signal from the next stage to pull down the levels at the first node PU and the output terminal Output(n) at the present stage.

In addition, for a gate line driving apparatus according to another embodiment of the disclosure, it can be known from the descriptions for Figs. 2-3, that the output terminal Output(n) of the N^{th} shifting register feeds back a feedback signal to the (N-1)^{th} shifting register (that is, serves as the feedback signal terminal Reset(n-1) at the previous stage) to switch off the (N-1)^{th} shifting register, and at the same time, the trigger signal terminal Input(n+1) of the shifting register at the N^{th} stage outputs a signal to the (N+1)^{th} shifting register, which serves as a trigger signal for the (N+1)^{th} shifting register.

As mentioned above, the shifting register at each stage in the gate line driving apparatus in accordance with the another embodiment of the disclosure excludes the third TFT M3, and the output terminal Output(n) at the present stage connected to the drain of the second TFT M2 can directly serve as a trigger signal terminal Input(n+1) for the next stage simultaneously. Besides the exclusion of the third TFT M3, the operation on the shifting register is the same as that of the shifting register in the gate line driving apparatus in the embodiment of the disclosure, and the details are omitted.

It tends to form and accumulate electrons on the gate insulation layer of a thin film transistor if a voltage is applied to the thin film transistor all the time, and thus it causes the threshold voltage of the thin film transistor to shift. In the gate line driving apparatus according to the embodiments of the disclosure, by applying a high level to the source of the TFT and a low level to the gate thereof, according to the principle of the tunneling effect and the quantum mechanics, the electrons formed and accumulated on the gate insulation layer of the TFT can pass the potential barrier and arrive at the source of the TFT, and thus it decreases the threshold voltage shifting of the TFT in the shifting register corresponding to each gate line, and finally it enables the shifting register circuit to operate normally, improving the stability of the shifting register in operation and extending the lifespan of the shifting register.

It should be illustrated that the shifting register used in the gate line driving apparatus according to the embodiments has the same function and structure as those of the shifting register used in the embodiments for the shifting register, and thus that they can solve the same technical problem, achieve the same expected effect.

The disclosure also provides a display device comprising a pixel array and the gate line driving apparatus as described above.

Although the embodiments of the disclosure are described in the field of liquid crystal display, they can be applied in the field of other display based on pixel array, such as AMOLED(Active Matrix Organic Light Emitting Diode) etc.

The above descriptions are only for the specific implementations of the disclosure, and the scope of the disclosure are not limited thereto. All the variations or alternations which are easily thought out by those skilled in the art in the light of the present disclosure, should be covered in the scope of the disclosure. The protection scope is defined by the attached claims.

## Claims

1. A shifting register comprising a stage, wherein the stage comprises:
a first TFT (M1), having a gate and a source connected together and further connected to a trigger signal terminal (Input(n)) of the stage, and a drain connected to a first node (PU) as a pull-up node;
a second TFT, having a gate connected to the first node, a source connected to a clock signal terminal (CLK), and a drain connected to an output terminal (Output(n)) of the stage;
a capacitor (C1), being connected between the first node and the output terminal (Output(n)) of the stage;
a resetting module (1), being connected between a second node (PL), the clock signal terminal (CLK) and a low level signal terminal (Vss); and
a feedback receiving module (2), being connected between the first node (PU), the low level signal terminal (Vss) and the output terminal (Output(n)) of the stage, and further being connected to a feedback signal terminal (Reset(n+1));
wherein, the resetting module (1) comprises:
a first resetting TFT (Tl), having a source connected to a drain of a third resetting TFT (T3), a drain connected to the low level signal terminal (Vss), and a gate directly connected to the second node (PL), the second node (PL) being directly connected to the output terminal (Output(n)) of the stage;
a second resetting TFT (T2), having a source connected to a drain of a fourth resetting TFT (T4), a drain connected to the low level signal terminal (Vss), and a gate directly connected to the second node (PL);
the third resetting TFT (T3), having a gate and a source connected to the clock signal terminal (CLK), and the drain connected to the source of the first resetting TFT (T1); and
the fourth resetting TFT (T4), having a gate connected to the drain of the third resetting TFT (T3), a source connected to the clock signal terminal (CLK), and the drain connected to the source of the second resetting TFT (T2),
wherein, the feedback receiving module (2) comprises:
a fourth TFT (M4), having a gate connected to the feedback signal terminal (Reset(n+1)), a source connected to the output terminal (Output(n)) of the stage, and a drain connected to the low level signal terminal (Vss); and
a fifth TFT (M5), having a gate connected to the feedback signal terminal (Reset(n+1)), a source connected to the first node (PU), and a drain connected to the low level signal terminal (Vss);
the stage further comprises:
a tenth TFT (M10), having a gate connected to the source of the second resetting TFT (T2) in the resetting module (1), a source connected to the output terminal (Output(n)) of the stage, and a drain connected to the low level signal terminal (Vss), and
an eighth TFT (M8), having a gate connected to the clock signal terminal (CLK), a source connected to the first node (PU), and a drain directly connected to the second node (PL),
**characterized in that**:
the stage comprises a ninth TFT (M9) having a gate connected to the source of the second resetting TFT (T2) in the resetting module, a source connected to the first node (PU), and a drain connected to the low level signal terminal (Vss).

2. The shifting register according to claim 1, wherein, the stage further comprises:
a sixth TFT (M6), having a gate connected to a second clock signal terminal(CLKB), a source connected to the second node (PL), and a drain connected to the low signal terminal (Vss), wherein a clock signal at the second clock signal terminal (CLKB) and that at the clock signal terminal (CLK) are inverted each other.

3. The shifting register according to claim 1, wherein, the stage further comprises:
a seventh TFT (M7), having a gate connected to the second clock signal terminal (CLKB), a source connected to the trigger signal terminal (Input(n)) of the stage, and a drain connected to the first node (PU), wherein a clock signal at the second clock signal terminal (CLKB) and that at the clock signal terminal (CLK) are inverted each other.

4. The shifting register according to claim 1, wherein, the stage further comprises:
a third TFT (M3), having a gate connected to the first node (PU), a source connected to the clock signal terminal (CLK), and a drain connected to the trigger signal terminal (Input(n+1)) for the next stage.

5. A gate line driving apparatus comprising the shifting register according to any one of claims 1-4, wherein the shift register comprises a plurality of stages ; wherein
the output terminal of a present stage of shift register is connected to the feedback signal terminal of a previous stage of shift register and a corresponding gate line.

6. A display device comprising a pixel array and the gate line driving apparatus according to claim 5.

7. A gate line driving method suitable for controlling the gate line driving apparatus according to claim 5, comprising:
applying a high level to the trigger signal terminal(Input(n)) to pull up the first node(PU) so as to turn on the second TFT, and inputting a low level to the clock signal terminal(CLK) to output the low level at the output terminal(Output(n)) via the second TFT;
inputting a high level to the clock signal terminal(CLK) to turn on the eighth TFT(M8) and maintain the first node(PU) at a high level, and providing the gate line with the high level via the second TFT to drive the gate line to be switched on;
applying a high level to the feedback signal terminal (Reset(n+1)) to turn on the fourth and fifth TFTs to pull down the output terminal(Output(n)) and the first node(PU) respectively;
applying a high level to the clock signal terminal(CLK) to apply the high level to the source of the second TFT, turning on the eighth TFT to maintain the first node(PU) at the low level so as to apply the low level to the gate of the second TFT.

## Patentansprüche

1. Schieberegister, umfassend eine Stufe, wobei die Stufe umfasst:
einen ersten TFT (M1), aufweisend ein Gate und eine Source, die miteinander verbunden sind und außerdem an einen Trigger-Signalanschluss (Input(n)) der Stufe angeschlossen sind, und einen Drain, der an einen ersten Knoten (PU) als ein Pull-Up-Knoten angeschlossen ist;
einen zweiten TFT, aufweisend ein Gate, das an den ersten Knoten angeschlossen ist, eine Source, die an einen Taktsignalanschluss (CLK) angeschlossen ist, und einen Drain, der an einen Ausgabeanschluss (Output(n)) der Stufe angeschlossen ist;
einen Kondensator (C1), geschaltet zwischen den ersten Knoten und den Ausgabeanschluss (Output(n)) der Stufe;
ein Rückstellmodul (1), geschaltet zwischen einen zweiten Knoten (PL), den Taktsignalanschluss (CLK) und einen Niedrig-Pegel-Signalanschluss (Vss); und
ein Feedback-Empfangsmodul (2), geschaltet zwischen den ersten Knoten (PU), den Niedrig-Pegel-Signalanschluss (Vss) und den Ausgabeanschluss (Output(n)) der Stufe und außerdem angeschlossen an einen Feedback-Signalanschluss (Reset(n+1));
wobei das Rückstellmodul (1) umfasst:
einen ersten Rückstell-TFT (T1), aufweisend eine Source, die an einen Drain von einem dritten Rückstell-TFT (T3) angeschlossen ist, einen Drain, der an den Niedrig-Level-Signalanschluss (Vss) angeschlossen ist, und ein Gate, das direkt an den zweiten Knoten (PL) angeschlossen ist, wobei der zweiten Knoten (PL) direkt an den Ausgabeanschluss (Output(n)) der Stufe angeschlossen ist;
einen zweiten Rückstell-TFT (T2), aufweisend eine Source, die an einen Drain eines vierten Rückstell-TFT (T4) angeschlossen ist, einen Drain, der an den Niedrig-Pegel-Signalanschluss (Vss) angeschlossen ist, und ein Gate, das direkt an den zweiten Knoten (PL) angeschlossen ist;
den dritten Rückstell-TFT (T3), aufweisend ein Gate und eine Source, angeschlossen an den Taktsignalanschluss (CLK), und wobei der Drain an die Source des ersten Rückstell-TFT (T1) angeschlossen ist; und
den vierten Rückstell-TFT (T4), aufweisend ein Gate, das an den Drain des dritten Rückstell-TFT (T3) angeschlossen ist, eine Source, die an den Taktsignalanschluss (CLK) angeschlossen ist, und den Drain, angeschlossen an die Source des zweiten Rückstell-TFT (T2),
wobei das Feedback-Empfangsmodul (2) umfasst:
einen vierten TFT (M4), aufweisend ein Gate, das an den Feedback-Signalanschluss (Reset(n+1)) angeschlossen ist, eine Source, angeschlossen an den Ausgabeanschluss (Output(n)) der Stufe, und einen Drain, angeschlossen an den Niedrig-Pegel-Signalanschluss (Vss); und
einen fünften TFT (M5), aufweisend ein Gate, das an den Feedback-Signalanschluss (Reset(n+1)) angeschlossen ist, eine Source, die an den ersten Knoten (PU) angeschlossen ist und einen Drain, der an den Niedrig-Pegel-Signalanschluss (Vss) angeschlossen ist;
wobei die Stufe weiterhin umfasst:
einen zehnten TFT (M10), aufweisend ein Gate, das an die Source des zweiten Rückstell-TFT (T2) in dem Rückstell-Modul (1) angeschlossen ist, eine Source, die an den Ausgabeanschluss (Output(n)) der Stufe angeschlossen ist und einen Drain, der an den Niedrig-Pegel-Signalanschluss (Vss) angeschlossen ist, und
einen achten TFT (M8), aufweisend ein Gate, das an den Taktsignalanschluss (CLK) angeschlossen ist, eine Source, die an den ersten Knoten (PU) angeschlossen ist, und einen Drain, der direkt an den zweiten Knoten (PL) angeschlossen ist,
**dadurch gekennzeichnet, dass**
die Stufe einen neunten TFT (M9) umfasst, aufweisend ein Gate, das an die Source des zweiten Rückstell-TFT (T2) in dem Rückstellmodul angeschlossen ist, eine Source, die an den ersten Knoten (PU) angeschlossen ist, und einen Drain, der an den Niedrig-Pegel-Signalanschluss (Vss) angeschlossen ist.

2. Schieberegister gemäß Anspruch 1, wobei die Stufe weiterhin umfasst:
einen sechsten TFT (M6), aufweisend ein Gate, das an einen zweiten Taktsignalanschluss (CLKB) angeschlossen ist, eine Source, die an den zweiten Knoten (PL) angeschlossen ist, und einen Drain, der an den Niedrigsignalanschluss (Vss) angeschlossen ist, wobei ein Taktsignal an dem zweiten Taktsignalanschluss (CLKB) und das an dem Taktsignalanschluss (CLK) invertiert zueinander sind.

3. Schieberegister gemäß Anspruch 1, wobei die Stufe weiterhin umfasst:
einen siebten TFT (M7), aufweisend ein Gate, das an den zweiten Taktsignalanschluss (CLKB) angeschlossen ist, eine Source, die an den Trigger-Signalanschluss (Input(n)) der Stufe angeschlossen ist, und einen Drain, der an den ersten Knoten (PU) angeschlossen ist, wobei ein Taktsignal an dem zweiten Taktsignalanschluss (CLKB) und das an dem Taktsignalanschluss (CLK) invertiert zueinander sind.

4. Schieberegister gemäß Anspruch 1, wobei die Stufe weiterhin umfasst:
einen dritten TFT (M3), aufweisend ein Gate, das an den ersten Knoten (PU) angeschlossen ist, eine Source, die an den Taktsignalanschluss (CLK) angeschlossen ist, und einen Drain, der an den Trigger-Signalanschluss (Input(n+1)) für die nächste Stufe angeschlossen ist.

5. Gateleitungs-Ansteuervorrichtung, umfassend das Schieberegister gemäß einem der Ansprüche 1-4, wobei das Schieberegister eine Mehrzahl von Stufen umfasst; wobei
der Ausgabeanschluss einer gegenwärtigen Stufe des Schieberegisters an den Feedback-Signalanschluss einer vorangehenden Stufe des Schieberegisters und eine korrespondierende Gate-Leitung angeschlossen ist.

6. Anzeigevorrichtung, umfassend ein Pixel-Array und die Gateleitungs-Ansteuervorrichtung gemäß Anspruch 5.

7. Gateleitungs-Ansteuerverfahren, geeignet zur Steuerung der Gateleitungs-Ansteuervorrichtung gemäß Anspruch 5, umfassend:
Anlegen eines hohen Pegels an den Trigger-Signalanschluss (Input(n)), um den ersten Knoten (PU) hochzuziehen, so dass der zweite TFT eingeschaltet wird, und Eingeben eines niedrigen Pegels an den Taktsignalanschluss (CLK), um den niedrigen Pegel an dem Ausgabeanschluss (Output(n)) mittels des zweiten TFT auszugeben;
Eingeben eines hohen Pegels an den Taktsignalanschluss (CLK), zum Einschalten des achten TFT (M8) und Halten des ersten Knotens (PU) bei einem hohen Level, und Versorgen der Gate-Leitung mit dem hohen Pegel mittels des zweiten TFT, um die Gate-Leitung anzusteuern, eingeschaltet zu werden;
Anlegen eines hohen Pegels an den Feedback-Signalanschluss (Reset(n+1)), um die vierten und fünften TFTs einzuschalten, um den Ausgabeanschluss (Output(n)) bzw. den ersten Knoten (PU) herunterzuziehen;
Anlegen eines hohen Pegels an den Taktsignalanschluss (CLK), um einen hohen Pegel an die Source des zweiten TFT anzulegen, Einschalten des achten TFT, um den ersten Knoten (PU) bei dem niedrigen Pegel zu halten, so dass der niedrige Pegel an das Gate des zweiten TFT angelegt wird.

## Revendications

1. Un registre à décalage comprenant un étage, dans lequel l'étage comprend :
un premier TFT (M1), ayant une grille et une source connectées ensemble et connectées en outre à une borne de signal de déclenchement (Entrée(n)) de l'étage, et un drain connecté à un premier noeud (PU) comme noeud d'excursion haute ;
un deuxième TFT, ayant une grille connectée au premier noeud, une source connectée à une borne de signal d'horloge (CLK), et un drain connecté à une borne de sortie (Output(n)) de l'étage ;
un condensateur (Cl), connecté entre le premier noeud et la borne de sortie (Output(n)) de l'étage ;
un module de remise à zéro (1), connecté entre un deuxième noeud (PL), la borne de signal d'horloge (CLK) et une borne de signal de niveau bas (Vss) ; et
un module de réception de rétroaction (2), connecté entre le premier noeud (PU), la borne de signal de niveau bas (Vss) et la borne de sortie (Output(n)) de l'étage, et connecté en outre à une borne de signal de rétroaction (Reset(n+1)) ;
dans lequel le module de remise à zéro (1) comprend :
un premier TFT de remise à zéro (Tl), ayant une source connectée à un drain d'un troisième TFT de remise à zéro (T3), un drain connecté à la borne de signal de niveau bas (Vss), et une grille directement connectée au deuxième noeud (PL), le deuxième noeud (PL) étant directement connecté à la borne de sortie (Output (n)) de l'étage ;
un deuxième TFT de remise à zéro (T2), ayant une source connectée à un drain d'un quatrième TFT de remise à zéro (T4), un drain connecté à la borne de signal de niveau bas (Vss), et une grille directement connectée au deuxième noeud (PL) ;
le troisième TFT de remise à zéro (T3), comportant une grille et une source connectées à la borne de signal d'horloge (CLK), et le drain connecté à la source du premier TFT de remise à zéro (T1) ; et
le quatrième TFT de remise à zéro (T4), comportant une grille connectée au drain du troisième TFT de remise à zéro (T3), une source connectée à la borne de signal d'horloge (CLK), et le drain connecté à la source du deuxième TFT de remise à zéro (T2),
dans lequel le module de réception de rétroaction (2) comprend :
un quatrième TFT (M4), ayant une grille connectée à la borne de signal de rétroaction (Reset(n+1)), une source connectée à la borne de sortie (Output(n)) de l'étage, et un drain connecté à la borne de signal de niveau bas (Vss) ; et
un cinquième TFT (M5), ayant une grille connectée à la borne de signal de rétroaction (Reset(n+1)), une source connectée au premier noeud (PU), et un drain connecté à la borne de signal de niveau bas (Vss) ;
l'étage comprenant en outre :
un dixième TFT (M10), ayant une grille connectée à la source du deuxième TFT de remise à zéro (T2) dans le module de remise à zéro (1), une source connectée à la borne de sortie (Output(n)) de l'étage, et un drain connecté à la borne de signal de niveau bas (Vss), et
un huitième TFT (M8), comportant une grille connectée à la borne de signal d'horloge (CLK), une source connectée au premier noeud (PU), et un drain directement connecté au deuxième noeud (PL),
**caractérisé en ce que** :
l'étage comprend un neuvième TFT (M9) ayant une grille connectée à la source du deuxième TFT de remise à zéro (T2) dans le module de remise à zéro, une source connectée au premier noeud (PU), et un drain connecté à la borne de signal de niveau bas (Vss).

2. Le registre à décalage selon la revendication 1, dans lequel l'étage comprend en outre :
un sixième TFT (M6), comportant une grille connectée à une deuxième borne de signal d'horloge (CLKB), une source connectée au deuxième noeud (PL), et un drain connecté à la borne de signal bas (Vss), dans lequel un signal d'horloge à la deuxième borne de signal d'horloge (CLKB) et celui à la borne de signal d'horloge (CLK) sont inversés l'un par rapport l'autre.

3. Le registre à décalage selon la revendication 1, dans lequel l'étage comprend en outre :
un septième TFT (M7), comportant une grille connectée à la deuxième borne de signal d'horloge (CLKB), une source connectée à la borne de signal de déclenchement (Input(n)) de l'étage, et un drain connecté au premier noeud (PU), dans lequel un signal d'horloge à la deuxième borne de signal d'horloge (CLKB) et celui au terminal de signal d'horloge (CLK) sont inversés l'un par rapport l'autre.

4. Le registre à décalage selon la revendication 1, dans lequel l'étage comprend en outre :
un troisième TFT (M3), comportant une grille connectée au premier noeud (PU), une source connectée à la borne de signal d'horloge (CLK) et un drain connecté à la borne de signal de déclenchement (Entrée(n+1)) pour l'étage suivant.

5. Un appareil de commande de lignes de grille comprenant le registre à décalage selon l'une quelconque des revendications 1 à 4, dans lequel le registre à décalage comprend une pluralité d'étages ; dans lequel
la borne de sortie d'un étage actuel du registre à décalage est connectée à la borne de signal de rétroaction d'un étage précédent du registre à décalage et à une ligne de grille correspondante.

6. Un dispositif d'affichage comprenant un réseau de pixels et l'appareil de commande de lignes de grille selon la revendication 5.

7. Un procédé de commande de lignes de grille apte à commander l'appareil de commande de lignes de grille selon la revendication 5, comprenant :
l'application d'un niveau haut à la borne de signal de déclenchement (Entrée(n)) pour tirer vers le haut le premier noeud (PU) de manière à allumer le deuxième TFT, et entrer un niveau bas à la borne de signal d'horloge (CLK) pour sortir le niveau bas à la borne de sortie (Sortie(n)) via le deuxième TFT ;
l'application en entrée d'un niveau haut à la borne de signal d'horloge (CLK) pour activer le huitième TFT (M8) et maintenir le premier noeud (PU) à un niveau haut, et la fourniture du niveau haut à la ligne de grille via le deuxième TFT pour commander la ligne de grille de manière à l'activer ;
l'application d'un niveau haut à la borne de signal de rétroaction (Reset(n+ 1)) pour activer les quatrième et cinquième TFTs pour tirer vers la bas respectivement la borne de sortie (Output(n)) et le premier noeud (PU) ;
l'application d'un niveau haut à la borne de signal d'horloge (CLK) pour appliquer le niveau haut à la source du deuxième TFT, l'activation du huitième TFT pour maintenir le premier noeud (PU) au niveau bas de manière à appliquer le niveau bas à la grille du deuxième TFT.
